# EUROPEAN PATENT SPECIFICATION

(11) **EP 0 372 514 B1**
(45) Date of publication and mention of the grant of the patent: **05.03.1997**
(21) Application number: 89122467.7
(22) Date of filing: 06.12.1989
(51) Int. Cl.: H04N 5/907, G09G 1/16, H04N 1/21

(54) **Image pick-up system**
Bildaufnahmesystem
Système pour prendre des images

(30) Priority: 06.12.1988 JP 308169/88; 09.12.1988 JP 309933/88
(43) Date of publication of application: 13.06.1990
(73) Proprietor: CANON KABUSHIKI KAISHA, Tokyo (JP)
(72) Inventor: Horii, Hiroyuki, Yokohama-shi Kanagawa-ken (JP); Date, Nobuaki, Kawasaki-shi Kanagawa-ken (JP); Mimura, Toshihiko, Yokohama-shi Kanagawa-ken (JP); Tojo, Akihiko, Yokohama-shi Kanagawa-ken (JP); Kawamura, Hideaki, Kawasaki-shi Kanagawa-ken (JP); Murata, Yoshitaka, Yokohama-shi Kanagawa-ken (JP); Takaiwa, Kan, Tokyo (JP); Suzuki, Takashi, Yokohama-shi Kanagawa-ken (JP); Ozaki, Seiichi, Yokohama-shi Kanagawa-ken (JP); Taira, Junzo, Tokyo (JP); Nagasawa, Kenichi, Kawasaki-shi Kanagawa-ken (JP)
(74) Representative: Tiedtke, Harro, Dipl.-Ing.

(56) References cited:
- EP-A- 0 195 608
- EP-A- 0 323 194
- DD-A- 254 095
- PATENT ABSTRACTS OF JAPAN vol. 9, no. 225 (E-342) 11 September 1985, & JP-A-60 081987 (MITSUBISHI DENKI) 10 May 1985,
- PATENT ABSTRACTS OF JAPAN vol. 13, no. 34 (E-708) 25 January 1989, & JP-A-63 232689 (TOSHIBA) 28 September 1988,

## Description

The present invention relates to an image pick-up system comprising a memory for storing image data.

Electronic still cameras employing magnetic floppy disks as the recording medium are already commercialized, but, owing to the decreasing cost and increasing level of integration of semiconductor memories, there are recently proposed electronic still camera systems employing solid-state memories such as semiconductor memories.

In use, as the recording medium, of a solid-state memory detachable from the camera body and composed of large-capacity IC memories, it is necessary to reduce the number of connecting lines with the camera body and to still enable rapid access. More specifically, the camera body and such solid-state memory apparatus are connected by a serial data line and several control lines for the purpose of achieving simpler connection, higher reliability and lower cost, since the usual parallel structure of data lines and address lines, employed in the incorporated image memory, increases the number of connecting lines, thus deteriorating the reliability and increasing the cost.

The serial data line is enough for ordinary operating modes which do not require random access to said solid-state memory, but high-speed random access capability in each image memory unit (block) is required, for example, in high-speed continuous photographing operation or in random reproduction of the photographed images.

Document EP-A-0 323 194, which is a publication in accordance with Art. 54(3) EPC, discloses a prior art arrangement of an electronic still camera and image recording method thereof. In particular, this arrangement discloses already a detachable memory mounted to the image pick-up device, with the addressing of the memory being dependent on the image data processing method. However, this document does not teach to perform an automatic response when mounting the memory to the image pick-up device. Rather, a manual switch for changing the image processing method has to be activated by the user of the apparatus. Moreover, the data block length to be addressed in the memory is fixed and constant for all image processing methods to be selected or adjusted, respectively.

It is therefore an object of the present invention to provide an improved image pick-up system in accordance with the preamble of the present claim 1, which system can be automatically adapted to the image processing method of said image pick-up device when said memory is attached to said image pick-up device.

This object is achieved by an image pick-up system as set out in claim 1.

Consequently, the image pick-up device needs only to send the information designating a memory block for which access is desired, to the solid-state memory, so that high-speed data transfer is made possible with a limited number of signal lines. Besides a single memory can be utilized effectively in common, even if different processing methods are involved.

The foregoing and still other objects of the present invention, and the advantages thereof, will become fully apparent from the following description of embodiments, which is to be taken in conjunction with the attached drawings.
Fig. 1 is a block diagram of an explanatory embodiment of an image pick-up system;
Fig. 2 is a block diagram of an IC memory in an embodiment of the present invention;
Fig. 3 is a view showing an example of connection between the IC memory shown in Fig. 2 and a camera;
Fig. 4 is a timing chart of data reading from a storage state holding memory;
Fig. 5 is a timing chart of data writing into said memory;
Fig. 6 is a view of a further embodiment of the connection of memory and camera; and
Fig. 7 a view showing an example of content of the storage state holding memory.

Now the present invention will be clarified by embodiments thereof shown in the attached drawings.

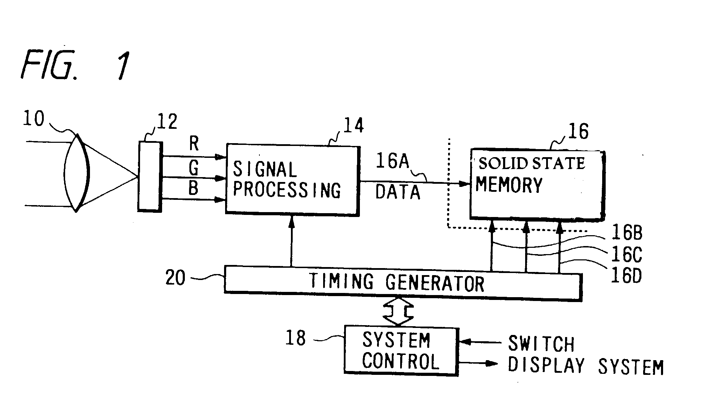

Fig. 1 is a block diagram of an explanatory embodiment of an image pick-up system, applied to a solid-state electronic still camera employing an IC memory. Light penetrating a photographing lens 10 enters an image sensor 12 which thus generates RGB signals corresponding to the object. A signal processing circuit 14 converts said RGB signals into image data, such as luminance data and color difference data, or converted RGB data. Said signal processing circuit 14 effects parallel-to-serial conversion on said image data, and serially sends said data to a solid-state memory 16 composed of an IC memory. A system control circuit 18 controls various circuit units, including a display device, in response to input signals for example from a shutter switch. A timing generator 20 sends a series of sequence timing signals to the signal processing ciucuit 14 and the solid-state memory 16, in response to the instructions from the system control circuit 18.

The lens 10, image sensor 12, signal processing circuit 14, system control circuit 18 and timing control circuit 20 are incorporated in the camera body, while the solid-state memory 16 is detachable therefrom. Said solid-state memory 16 is connected to the camera body through a serial data line 16A, a clock line 16D, an address/control line 16C and a status line 16B. Naturally there are additional lines such as power supply lines and various auxiliary signal lines, but they are omitted in the drawing since they are not directly related to the present invention.

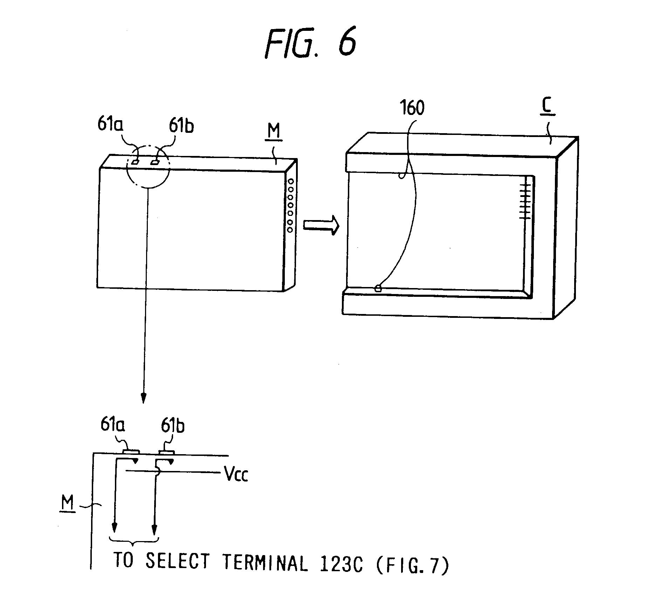

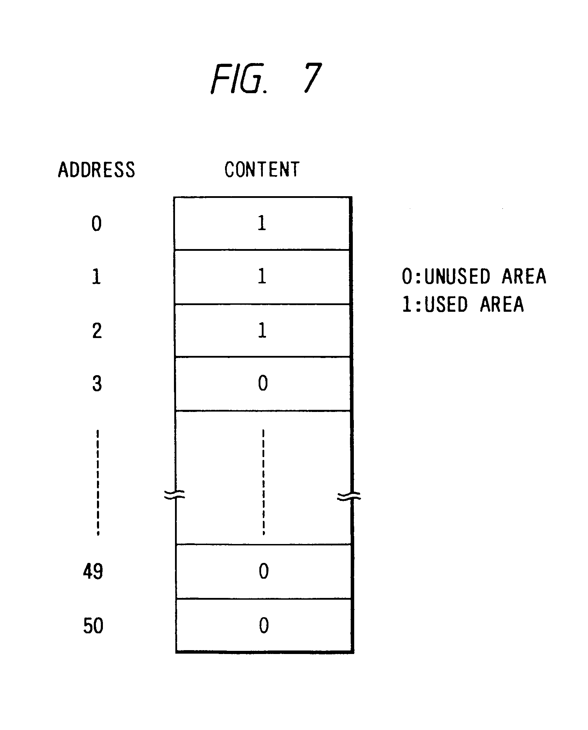

In the foregoing embodiment, the camera body and the solid-state memory 16 are connected by four signal lines, but it is also possible to unit the clock line 16D and the data line 16A, or to expand functions by adding another control line (for example storage disable line). The status line 16B is usually used for confirming the content of a storage state holding member of the solid-state memory as shown, for example, in Fig. 7, but it may naturally be used for other purposes. The storage of image data in the solid-state memory 16 may be made in various modes, such as by NTSC or PAL signals, by luminance and color difference signals, by RGB signals, or by compressed signals.

As will be easily understood from the foregoing, the present embodiment enables high-speed access to an arbitrary data block with a limi ed number of signal lines. Also the image pick-up device is relieved from the burden of memory administration and address calculation.

In the foregoing embodiment, the serial data line is enough for access because normal operating modes do not involve random access to the solid-state memory apparatus, but a high-speed random access capability is required for each image memory block for example in case of high-speed continuous photographing operation or random reproduction of photographed images.

In the following there will be explained another embodiment of the solid-state memory requiring only a limited number of connecting lines, still having random access capability and enabling to use a common memory regardless of the image processing methods.

Since the structure shown in Fig. 1 employs a fixed ROM in an address generator, the memory can no longer be used if the image processing method of the camera (for example NTSC, PAL HD, SECAM, Hi-band etc.) is changed, thus varying the data length.

On the other hand, the following embodiment in accordance with the invention allows common use of a memory even if the image processing method of the camera is changed.

For this purpose, the memory is equipped with means for identifying the image processing method employed in the camera, and with plural address generators.

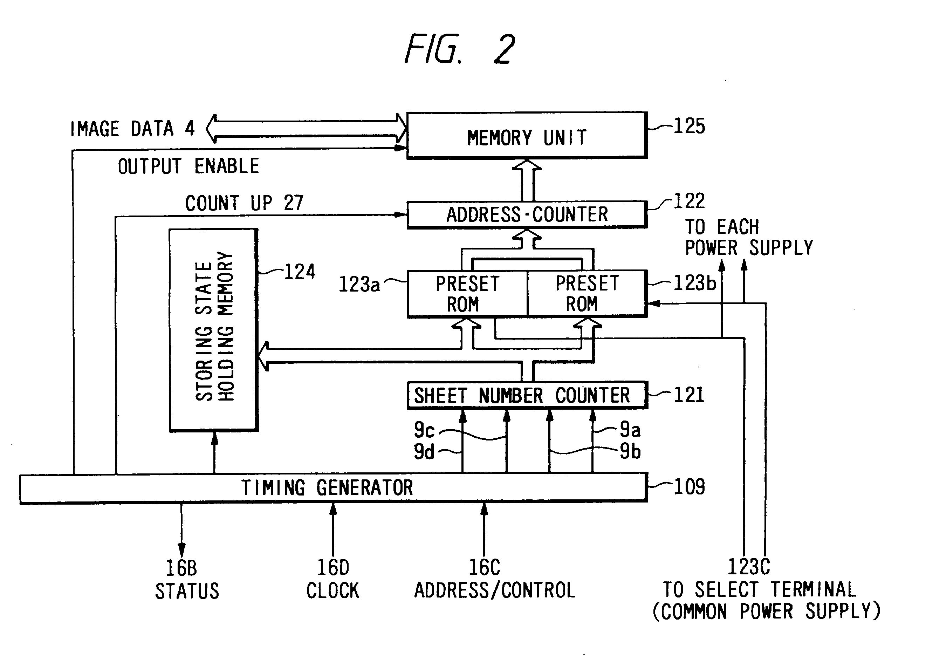

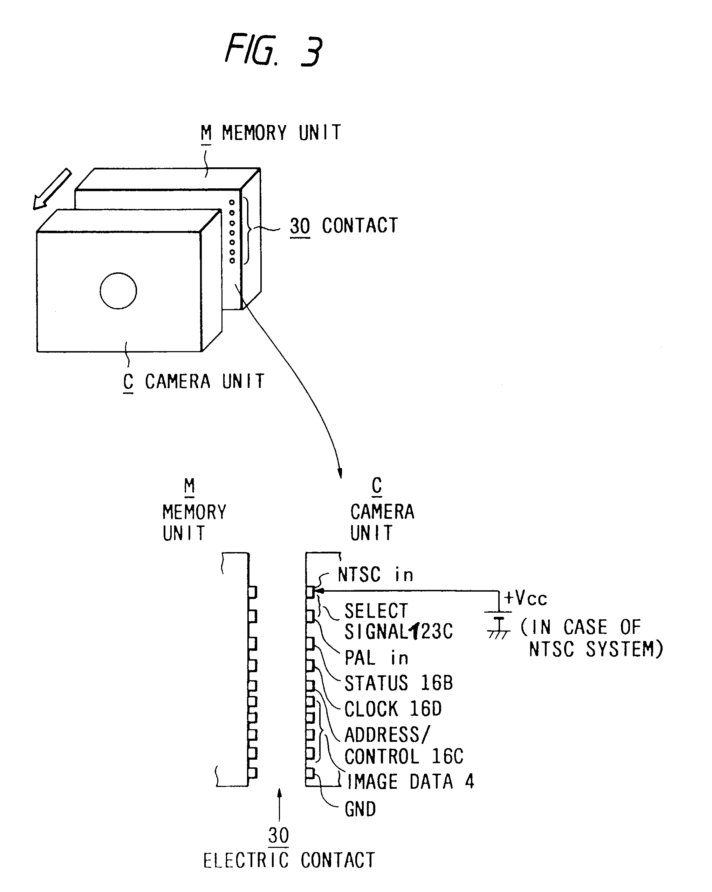

Fig. 2 is a block diagram of an embodiment of the IC memory system of the present invention, and Fig. 3 shows an example of connection between the memory and the camera.

The present embodiment provides a solid-state memory apparatus (pack) for NTSC and PAL systems, wherein two preset ROM's 123a, 123b are provided for setting the address counter 122. A select signal 123c for said ROM's 123a/b is given by a contact of the electronic camera C. The camera C is equipped with a contact indicating the image processing system therein, so that the memory M can automatically identify NTSC or PAL system.

In the structure shown in Fig. 2, there are provided an IC (main) memory 125 capable of random access; an address counter 122; a preset ROM 123a for NTSC system; a preset ROM 123b for PAL system; a storage state holding memory 124; a sheet number counter 121; and a timing signal generator 109.

### (Operation)

In the following there will be explained the function of the above-explained embodiment.

At first, the selection of the preset ROM 123a or 123b is automatically made by mounting the memory apparatus M on the camera C as shown in Fig. 3. As will be apparent from Fig. 3 which is a magnified view of connectors of the memory M and camera C, the ROM 123a or 123b is automatically selected according to whether a terminal NTSC IN or PAL IN on the camera is powered. The camera C releases an access command signal to the storage state holding memory 124 from an address/control terminal 16C, for confirming the presence of an empty space in the memory 125. After a subsequent photographing operation, the camera C releases a write command signal from the address/control terminal 16C, and sends out image and audio data 4 in synchronization with the clock signal 16D for successive storage in the memory 125.

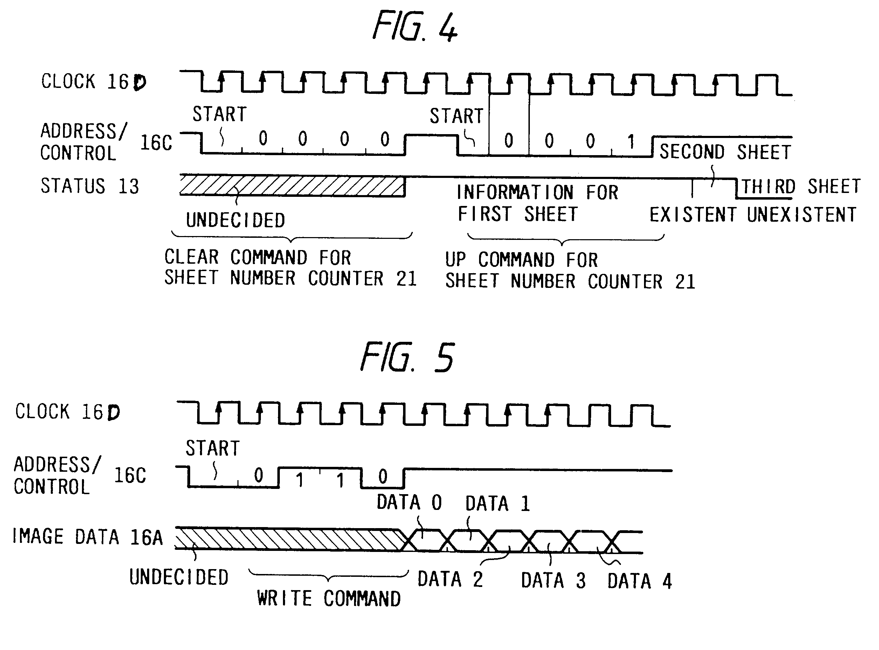

Fig. 4 is a timing chart showing a representative example of readout of an empty area of the storage state holding memory 124, and Fig. 5 is a timing chart showing a representative example of data storage.

Fig. 6 shows a further embodiment of the connection of the camera and the IC memory unit of the invention. In the embodiment a pair of mechanical projections 160 are provided on the camera C for stabilizing the connection between the memory M and the camera C, and the memory unit M is provided with holes 61a, 61b respectively corresponding to the NTSC and PAL systems. As shown in partial magnified view, said projection 160 engages with either of said holes 161a, 161b, whereby the memory M can detect the characteristic of the camera C, and utilizes the result of said detection for selecting the preset ROM 123a or 123b as in the memory apparatus as shown in Fig. 2. The memory M can dispense with additional mechanical structures in such embodiment.

As explained in the foregoing, the present embodiment, featured by the presence of plural address generators for the memory, provides a memory unit not fixed to the data size of NTSC or PAL system, so that a same memory can be utilized regardless of the image processing system of the electronic camera.

## Claims

1. An image pick-up system comprising
an image-pick-up device (10, 12) operating according to a predetermined signal processing method, and
a memory (16) for storing image data generated by said image pick-up device (10, 12),
said memory (16) being capable of random access and
detachably mountable on said image pick-up device (10, 12),
said system further comprising
an address generation means (122) for generating start address information for each of image data blocks to be stored in said memory (16); said system further comprising
a control means (18; 123a, 123b) for controlling said address generation means (122),
**characterized in that**
a detection means (123C) is provided which,
when said memory (16) is mounted on said image pick-up device (10, 12),
automatically detects said predetermined signal processing method of said image pick-up device (10, 12) and
generates an output signal in accordance with the detected signal processing method,
by means of which output signal
said control means (18; 123a, 123b) is controlled in such a manner that said address generation means (122) sets a start address of each of said image data blocks according to the detected signal processing method.

2. A system according to claim 1, wherein
said signal processing method is either NTSC or PAL.

3. A system according to claim 1, wherein
said address generation means (122) is provided within said memory (16).

## Patentansprüche

1. Bildaufnahmesystem mit
einer entsprechend einem vorbestimmten Signalverarbeitungsverfahren arbeitenden Bildaufnahmeeinrichtung (10, 12), und
einem Speicher (16) zum Speichern von durch die Bildaufnahmeeinrichtung (10, 12) erzeugten Bilddaten, wobei der Speicher (16) wahlfrei zugreifen kann und an der Bildaufnahmeeinrichtung (10, 12) abnehmbar befestigt sein kann,
wobei das System eine Adressengeneratoreinrichtung (122) zur Erzeugung von Anfangsadreßinformationen für jeden in dem Speicher (16) zu speichernden Bilddatenblöcke und
eine Steuereinrichtung (18; 123a, 123b) zur Steuerung der Adressengeneratoreinrichtung (122) aufweist,
**dadurch gekennzeichnet, daß**
eine Erfassungseinrichtung (123C) vorgesehen ist, die, wenn der Speicher (16) an der Bildaufnahmeeinrichtung (10, 12) befestigt ist, automatisch das vorbestimmte Signalverarbeitungsverfahren der Bildaufnahmeeinrichtung (10, 12) erfaßt und ein Ausgangssignal entsprechend dem erfaßten Signalverarbeitungsverfahren erzeugt,
wobei durch dieses Ausgangssignal die Steuereinrichtung (18, 123a, 123b) derart gesteuert wird, daß die Adressengeneratoreinrichtung (122) eine Anfangsadresse jedes Bilddatenblocks entsprechend dem erfaßten Signalverarbeitungsverfahren einstellt.

2. System nach Anspruch 1,
**dadurch gekennzeichnet, daß**
das Signalverarbeitungsverfahren entweder NTSC oder PAL ist.

3. System nach Anspruch 1,
**dadurch gekennzeichnet, daß**
die Adressengeneratoreinrichtung (122) in dem Speicher (16) vorgesehen ist.

## Revendications

1. Système de détection d'images comprenant
un dispositif de détection d'images (10, 12) fonctionnant selon un procédé de traitement de signaux prédéterminé, et
une mémoire (16) pour mémoriser des données d'images produites par ledit dispositif de détection d'images (10, 12),
ladite mémoire (16) permettant un accès aléatoire et pouvant être montée de façon amovible sur ledit dispositif de détection d'images (10, 12), ledit système comprenant en outre :
des moyens (122) de production d'adresses pour fournir une information d'adresse de démarrage pour chacun des blocs de données d'image devant être mémorisés dans ladite mémoire (16) ;
ledit système comprenant
des moyens de commande (18 ; 123a, 123b) pour commander lesdits moyens (122) de production d'adresses,
caractérisé en ce que
des moyens de détection (123C) sont prévus, qui,
lorsque ladite mémoire (16) est montée sur ledit dispositif de détection d'images (10, 12),
détectent automatiquement ledit procédé de traitement de signaux prédéterminé dudit dispositif de détection d'images (10, 12), et
produisent un signal de sortie en fonction du procédé de traitement de signaux détecté, signal de sortie au moyen duquel
lesdits moyens de commande (18 ; 123a, 123b) sont commandés de telle sorte que lesdits moyens (122) de production d'adresses règlent une adresse de démarrage de chacun desdits blocs de données d'image en fonction du procédé de traitement de signaux détecté.

2. Système selon la revendication 1, dans lequel ledit procédé de traitement de signaux est soit NTSC, soit PAL.

3. Système selon la revendication 1, dans lequel lesdits moyens (122) de production d'adresses sont disposés dans ladite mémoire (16).
